(19) **Europäisches Patentamt / European Patent Office / Office européen des brevets**

(11) **EP 3 171 472 A1**

(12) **EUROPEAN PATENT APPLICATION**

(43) Date of publication:
24.05.2017 Bulletin 2017/21

(51) Int Cl.:
*H02H 1/00* (2006.01)  *G01R 31/02* (2006.01)
*H02H 3/33* (2006.01)

(21) Application number: 16175329.8

(22) Date of filing: 20.06.2016

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 20.11.2015 TW 104138382

(71) Applicant: Delta Electronics, Inc.
Taoyuan County 32063 (TW)

(72) Inventors:
• LI, Chih-Chang
Taoyuan City 32063 (TW)
• HSIN, Wei-Lun
Taoyuan City 32063 (TW)
• LIN, Xin-Hung
Taoyuan City 32063 (TW)

(74) Representative: **2K Patentanwälte Blasberg Kewitz & Reichel Partnerschaft mbB Schumannstrasse 27 60325 Frankfurt am Main (DE)**

(54) **ARC DETECTION APPARATUS**

(57) An arc detection apparatus (10) includes an arc detection circuit (102), a current transforming unit (128), a current input wire (108) and a current output wire (110). A power supply apparatus (20) sends an input current (Iin_a) to an electronic apparatus (30) through the current input wire (108), and the electronic apparatus (30) sends back an output current (Iin_b) to the power supply apparatus (20) through the current output wire (110), so that the current transforming unit (128) induces and generates an induced current (112). The current transforming unit (128) sends the induced current (112) to the arc detection circuit (102). The arc detection circuit (102) utilizes the induced current (112) to detect an arc.

FIG.1

EP 3 171 472 A1

## Description

BACKGROUND OF THE INVENTION

Field of the Invention

The present invention relates to an arc detection apparatus, and especially relates to an improved arc detection apparatus

Description of the Related Art

The operating principle of the related art arc detector is briefly explained as following. When the wire is broken, for example when the wire is bitten by the small animal such that the wire diameter of the wire is decreased, the current flowing through the wire will generate a high frequency signal. Therefore, the related art arc detector detects the current flowing through the single wire and converts the current into the frequency spectrum for analyzing. If the high frequency component is too large, it means that the arc is generated. Meanwhile, the related art arc detector informs the electronic apparatus, so that the electronic apparatus is shutdown.

However, the power supply apparatus and the electronic apparatus have parasitic capacitance to ground, so that the current mentioned above is not an ideal current. Namely, the current mentioned above has some interference noises. The interference noises will impact the accuracy of the detection of the arc.

SUMMARY OF THE INVENTION

In order to solve the above-mentioned problems, an object of the present invention is to provide an arc detection apparatus.

In order to achieve the object of the present invention mentioned above, the arc detection apparatus is applied to a power supply apparatus and an electronic apparatus. The arc detection apparatus includes an arc detection circuit, a current transforming unit, a current input wire and a current output wire. The arc detection circuit is electrically connected to the electronic apparatus. The current transforming unit is electrically connected to the arc detection circuit. The current input wire penetrates the current transforming unit and is electrically connected to the power supply apparatus and the electronic apparatus. The current output wire penetrates the current transforming unit and is electrically connected to the power supply apparatus and the electronic apparatus. The power supply apparatus sends an input current to the electronic apparatus through the current input wire, and the electronic apparatus sends back an output current to the power supply apparatus through the current output wire, so that the current transforming unit induces and generates an induced current. The current transforming unit sends the induced current to the arc detection circuit. The arc detection circuit utilizes the induced current to detect an arc.

Moreover, in an embodiment, the current transforming unit comprises a toroidal core and a toroidal coil. The toroidal coil winds the toroidal core and is electrically connected to the arc detection circuit. An input current direction of the input current sent through the current input wire through the toroidal core is a first direction. An output current direction of the output current sent through the current output wire through the toroidal core is the first direction.

Moreover, in an embodiment, the first direction is from left to right. The input current is sent from left to right through the current input wire through the toroidal core. The output current is sent from left to right through the current output wire through the toroidal core.

Moreover, in an embodiment, the first direction is from right to left. The input current is sent from right to left through the current input wire through the toroidal core. The output current is sent from right to left through the current output wire through the toroidal core.

Moreover, in an embodiment, the current transforming unit comprises a first toroidal core, a second toroidal core, a first toroidal coil and a second toroidal coil. The first toroidal coil winds the first toroidal core and is electrically connected to the arc detection circuit. The second toroidal coil winds the second toroidal core and is electrically connected to the arc detection circuit. The power supply apparatus sends the input current to the electronic apparatus through the current input wire, so that the first toroidal core and the first toroidal coil induce and generate a first induced current. The electronic apparatus sends back the output current to the power supply apparatus through the current output wire, so that the second toroidal core and the second toroidal coil induce and generate a second induced current. An input current direction of the input current sent through the current input wire through the first toroidal core is a first direction. An output current direction of the output current sent through the current output wire through the second toroidal core is the first direction. The first toroidal coil sends the first induced current to the arc detection circuit. The second toroidal coil sends the second induced current to the arc detection circuit. The arc detection circuit utilizes the first induced current and the second induced current to detect the arc.

Moreover, in an embodiment, the first direction is from left to right. The input current is sent from left to right through the current input wire through the first toroidal core. The output current is sent from left to right through the current output wire through the second toroidal core.

Moreover, in an embodiment, the first direction is from right to left. The input current is sent from right to left through the current input wire through the first toroidal core. The output current is sent from right to left through the current output wire through the second toroidal core.

Moreover, in an embodiment, the current transforming unit comprises a first toroidal core, a second toroidal core, a first toroidal coil and a second toroidal coil. The first toroidal coil winds the first toroidal core and is electrically connected to the arc detection circuit. The second toroidal coil winds the second toroidal core and is electrically connected to the arc detection circuit. The power supply apparatus sends the input current to the electronic apparatus through the current input wire, so that the first toroidal core and the first toroidal coil induce and generate a first induced current. The electronic apparatus sends back the output current to the power supply apparatus through the current output wire, so that the second toroidal core and the second toroidal coil induce and generate a second induced current. An input current direction of the input current sent through the current input wire through the first toroidal core is a first direction. An output current direction of the output current sent through the current output wire through the second toroidal core is a second direction. The first direction is different from the second direction. The first toroidal coil sends the first induced current to the arc detection circuit. The second toroidal coil sends the second induced current to the arc detection circuit. The arc detection circuit reverses the second induced current to obtain a reverse induced current. The arc detection circuit utilizes the first induced current and the reverse induced current to detect the arc.

Moreover, in an embodiment, the arc detection circuit comprises a current reverse unit. The current reverse unit reverses the second induced current to obtain the reverse induced current.

Moreover, in an embodiment, the first direction is from left to right. The second direction is from right to left. The input current is sent from left to right through the current input wire through the first toroidal core. The output current is sent from right to left through the current output wire through the second toroidal core.

Moreover, in an embodiment, the first direction is from right to left. The second direction is from left to right. The input current is sent from right to left through the current input wire through the first toroidal core. The output current is sent from left to right through the current output wire through the second toroidal core.

The advantage of the present invention is to provide the arc detection apparatus to improve the accuracy of the detection of the arc.

BRIEF DESCRIPTION OF DRAWING

Fig. 1 shows a block diagram of the first embodiment of the arc detection apparatus of the present invention.
Fig. 2 shows a block diagram of the second embodiment of the arc detection apparatus of the present invention.
Fig. 3 shows a block diagram of the third embodiment of the arc detection apparatus of the present invention.

tion.
Fig. 4 shows a block diagram of the fourth embodiment of the arc detection apparatus of the present invention.

DETAILED DESCRIPTION OF THE INVENTION

Please refer to following detailed description and figures for the technical content of the present invention. The following detailed description and figures are referred for the present invention, but the present invention is not limited to it.

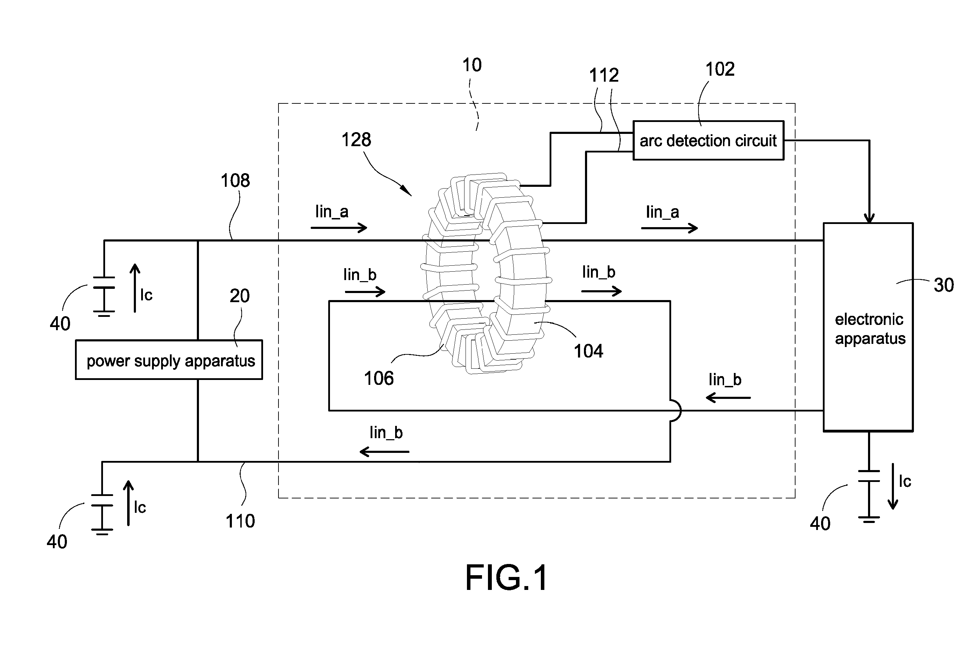

Fig. 1 shows a block diagram of the first embodiment of the arc detection apparatus of the present invention. An arc detection apparatus 10 is applied to a power supply apparatus 20 and an electronic apparatus 30. The arc detection apparatus 10 includes an arc detection circuit 102, a current transforming unit 128, a current input wire 108 and a current output wire 110. The current transforming unit 128 comprises a toroidal core 104 and a toroidal coil 106.

The arc detection circuit 102 is electrically connected to the electronic apparatus 30. The current transforming unit 128 is electrically connected to the arc detection circuit 102. The toroidal coil 106 winds the toroidal core 104 and is electrically connected to the arc detection circuit 102. The current input wire 108 penetrates the toroidal core 104 of the current transforming unit 128 and is electrically connected to the power supply apparatus 20 and the electronic apparatus 30. The current output wire 110 penetrates the toroidal core 104 of the current transforming unit 128 and is electrically connected to the power supply apparatus 20 and the electronic apparatus 30.

The power supply apparatus 20 sends an input current Iin_a to the electronic apparatus 30 through the current input wire 108, and the electronic apparatus 30 sends back an output current Iin_b to the power supply apparatus 20 through the current output wire 110, so that the toroidal core 104 of the current transforming unit 128 and the toroidal coil 106 of the current transforming unit 128 induce and generate an induced current 112.

An input current direction of the input current Iin_a sent through the current input wire 108 through the toroidal core 104 is a first direction. An output current direction of the output current Iin_b sent through the current output wire 110 through the toroidal core 104 is the first direction.

The toroidal coil 106 of the current transforming unit 128 sends the induced current 112 to the arc detection circuit 102. The arc detection circuit 102 utilizes the induced current 112 to detect an arc.

If the first direction is from left to right, the input current Iin_a is sent from left to right through the current input wire 108 through the toroidal core 104, and the output current Iin_b is sent from left to right through the current output wire 110 through the toroidal core 104.

If the first direction is from right to left, the input current Iin_a is sent from right to left through the current input wire 108 through the toroidal core 104, and the output current Iin_b is sent from right to left through the current output wire 110 through the toroidal core 104.

In short, the input current direction of the input current Iin_a is equal to the output current direction of the output current Iin_b. To take Fig. 1 as an example, taking the toroidal core 104 as a reference, when the input current Iin_a penetrates the toroidal core 104, the input current Iin_a is sent from left to right, and when the output current Iin_b penetrates the toroidal core 104, the output current Iin_b is sent from left to right.

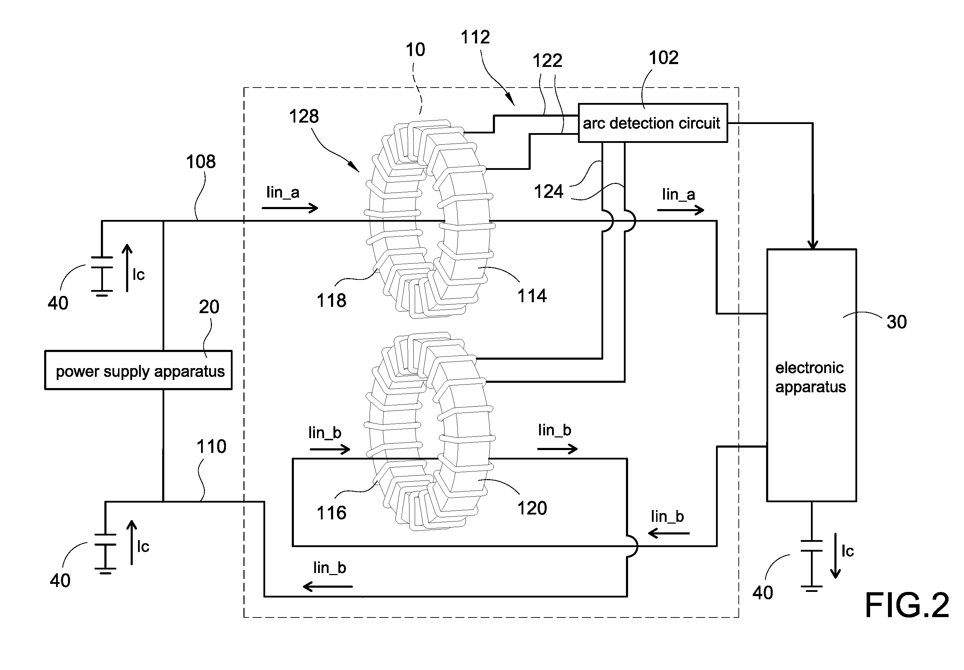

Fig. 2 shows a block diagram of the second embodiment of the arc detection apparatus of the present invention. An arc detection apparatus 10 is applied to a power supply apparatus 20 and an electronic apparatus 30. The arc detection apparatus 10 includes an arc detection circuit 102, a current transforming unit 128, a current input wire 108 and a current output wire 110. The current transforming unit 128 comprises a first toroidal core 114, a second toroidal core 120, a first toroidal coil 118 and a second toroidal coil 116.

The arc detection circuit 102 is electrically connected to the electronic apparatus 30. The current transforming unit 128 is electrically connected to the arc detection circuit 102. The first toroidal coil 118 winds the first toroidal core 114 and is electrically connected to the arc detection circuit 102. The second toroidal coil 116 winds the second toroidal core 120 and is electrically connected to the arc detection circuit 102. The current input wire 108 penetrates the first toroidal core 114 of the current transforming unit 128 and is electrically connected to the power supply apparatus 20 and the electronic apparatus 30. The current output wire 110 penetrates the second toroidal core 120 of the current transforming unit 128 and is electrically connected to the power supply apparatus 20 and the electronic apparatus 30.

The power supply apparatus 20 sends an input current Iin_a to the electronic apparatus 30 through the current input wire 108, and the electronic apparatus 30 sends back an output current Iin_b to the power supply apparatus 20 through the current output wire 110, so that the current transforming unit 128 induces and generates a induced current 112.

In another word, the power supply apparatus 20 sends the input current Iin_a to the electronic apparatus 30 through the current input wire 108, so that the first toroidal core 114 and the first toroidal coil 118 induce and generate a first induced current 122. The electronic apparatus 30 sends back the output current Iin_b to the power supply apparatus 20 through the current output wire 110, so that the second toroidal core 120 and the second toroidal coil 116 induce and generate a second induced current 124. The induced current 112 comprises the first induced current 122 and the second induced current 124.

An input current direction of the input current Iin_a sent through the current input wire 108 through the first toroidal core 114 is a first direction. An output current direction of the output current Iin_b sent through the current output wire 110 through the second toroidal core 120 is the first direction.

The current transforming unit 128 sends the induced current 112 to the arc detection circuit 102. In another word, the first toroidal coil 118 sends the first induced current 122 to the arc detection circuit 102. The second toroidal coil 116 sends the second induced current 124 to the arc detection circuit 102. The arc detection circuit 102 utilizes the induced current 112 (namely, utilizes the first induced current 122 and the second induced current 124) to detect an arc.

If the first direction is from left to right, the input current Iin_a is sent from left to right through the current input wire 108 through the first toroidal core 114, and the output current Iin_b is sent from left to right through the current output wire 110 through the second toroidal core 120.

If the first direction is from right to left, the input current Iin_a is sent from right to left through the current input wire 108 through the first toroidal core 114, and the output current Iin_b is sent from right to left through the current output wire 110 through the second toroidal core 120.

In short, the input current direction of the input current Iin_a is equal to the output current direction of the output current Iin_b. To take Fig. 2 as an example, taking the first toroidal core 114 as a reference, when the input current Iin_a penetrates the first toroidal core 114, the input current Iin_a is sent from left to right. Taking the second toroidal core 120 as a reference, when the output current Iin_b penetrates the second toroidal core 120, the output current Iin_b is sent from left to right.

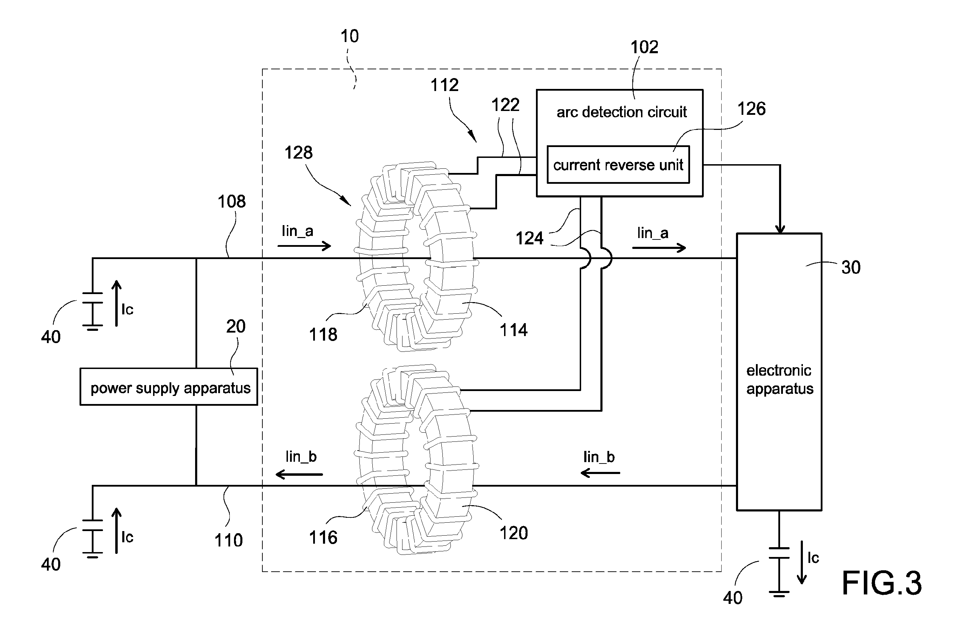

Fig. 3 shows a block diagram of the third embodiment of the arc detection apparatus of the present invention. An arc detection apparatus 10 is applied to a power supply apparatus 20 and an electronic apparatus 30. The arc detection apparatus 10 includes an arc detection circuit 102, a current transforming unit 128, a current input wire 108 and a current output wire 110. The current transforming unit 128 comprises a first toroidal core 114, a second toroidal core 120, a first toroidal coil 118 and a second toroidal coil 116. The arc detection circuit 102 comprises a current reverse unit 126.

The arc detection circuit 102 is electrically connected to the electronic apparatus 30. The current transforming unit 128 is electrically connected to the arc detection circuit 102. The first toroidal coil 118 winds the first toroidal core 114 and is electrically connected to the arc detection circuit 102. The second toroidal coil 116 winds the second toroidal core 120 and is electrically connected to the arc detection circuit 102. The current input wire 108 penetrates the first toroidal core 114 of the current transforming unit 128 and is electrically connected to the power supply apparatus 20 and the electronic apparatus 30. The current output wire 110 penetrates the second toroidal core 120 of the current transforming unit 128 and is electrically connected to the power supply apparatus 20 and the electronic apparatus 30.

The power supply apparatus 20 sends an input current Iin_a to the electronic apparatus 30 through the current input wire 108, and the electronic apparatus 30 sends back an output current Iin_b to the power supply apparatus 20 through the current output wire 110, so that the current transforming unit 128 induces and generates a induced current 112. In another word, the power supply apparatus 20 sends the input current Iin_a to the electronic apparatus 30 through the current input wire 108, so that the first toroidal core 114 and the first toroidal coil 118 induce and generate a first induced current 122. The electronic apparatus 30 sends back the output current Iin_b to the power supply apparatus 20 through the current output wire 110, so that the second toroidal core 120 and the second toroidal coil 116 induce and generate a second induced current 124. The induced current 112 comprises the first induced current 122 and the second induced current 124.

An input current direction of the input current Iin_a sent through the current input wire 108 through the first toroidal core 114 is a first direction. An output current direction of the output current Iin_b sent through the current output wire 110 through the second toroidal core 120 is a second direction. The first direction is different from the second direction.

The current transforming unit 128 sends the induced current 112 to the arc detection circuit 102. In another word, the first toroidal coil 118 sends the first induced current 122 to the arc detection circuit 102. The second toroidal coil 116 sends the second induced current 124 to the arc detection circuit 102. The arc detection circuit 102 reverses the second induced current 124 to obtain a reverse induced current. The arc detection circuit 102 utilizes the induced current 112 (namely, utilizes the first induced current 122 and the reverse induced current which is obtained by reversing the second induced current 124) to detect an arc. The current reverse unit 126 reverses the second induced current 124 to obtain the reverse induced current.

If the first direction is from left to right and the second direction is from right to left, the input current Iin_a is sent from left to right through the current input wire 108 through the first toroidal core 114, and the output current Iin_b is sent from right to left through the current output wire 110 through the second toroidal core 120.

If the first direction is from right to left and the second direction is from left to right, the input current Iin_a is sent from right to left through the current input wire 108 through the first toroidal core 114, and the output current Iin_b is sent from left to right through the current output wire 110 through the second toroidal core 120.

In short, the input current direction of the input current Iin_a is different from the output current direction of the output current Iin_b. To take Fig. 3 as an example, taking the first toroidal core 114 as a reference, when the input current Iin_a penetrates the first toroidal core 114, the input current Iin_a is sent from left to right. Taking the second toroidal core 120 as a reference, when the output current Iin_b penetrates the second toroidal core 120, the output current Iin_b is sent from right to left. Although the input current direction of the input current Iin_a is different from the output current direction of the output current Iin_b, the second induced current 124 (which is induced from the output current Iin_b) will be reversed to utilize.

Please refer to Fig. 1, Fig. 2 and Fig. 3 at the same time. Because the power supply apparatus 20 and the electronic apparatus 30 have a plurality of parasitic capacitors 40 to ground, there are a plurality of parasitic currents Ic, so that the input current Iin_a and the output current Iin_b are not ideal. Namely, the input current Iin_a and the output current Iin_b have some interference noises. The interference noises will impact the accuracy of the detection of the arc.

Iin_diff is indicated as the differential mode component of the current. Iin_com is indicated as the common mode component of the current. Therefore, the input current Iin_a and the output current Iin_b mentioned above of the present invention can be expressed as following equations:

$$Iin\_a = Iin\_diff + Iin\_com$$

$$Iin\_b = Iin\_diff - Iin\_com$$

If in an ideal condition, the common mode component (Iin_com) of the current should approach zero, but in fact it is not.

From the two equations and content mentioned above, no matter the arc detector only detects the input current Iin_a (namely, detects the power positive side) or only detects the output current Iin_b (namely, detects the power negative side), because there is the common mode component (Iin_com), the accuracy of the detection of the arc is decreased.

The circuit structures and contents shown in Fig. 1, Fig. 2 and Fig. 3 of the present invention adds the two equations mentioned above together to obtain following equation:

$$Iin\_a + Iin\_b = 2 * Iin\_diff$$

Only the differential mode component (Iin_diff) of the current is preserved, but the common mode component (Iin_com) of the current is eliminated, so that the accuracy of the detection of the arc is improved.

Moreover, although the input current direction of the input current Iin_a is different from the output current direction of the output current Iin_b in Fig. 3, the second induced current 124 (which is induced from the

output current lin_b) will be reversed to utilize, so that the equation mentioned above still can be used.

Moreover, the power supply apparatus 20 is, for example but not limited to, a solar panel. The electronic apparatus 30 is, for example but not limited to, an inverter. The arc detection circuit 102 utilizes, for example a digital signal processing chip, to convert the induced current 112 (or converts the first induced current 122 and the second induced current 124) into a frequency spectrum for analyzing. If a high frequency component of the frequency spectrum is too large (for example greater than a predetermined value), the arc is generated. Meanwhile, the arc detection circuit 102 informs the electronic apparatus 30, so that the electronic apparatus 30 is shutdown.

Moreover, in Fig. 2 and Fig. 3, a single of the arc detection circuit 102 receives the first induced current 122 and the second induced current 124. However, in another embodiment, the single of the arc detection circuit 102 is replaced by two of the arc detection circuits 102. One of the two of the arc detection circuits 102 receives the first induced current 122, and the other detection circuit 102 receives the second induced current 124.

Moreover, the toroidal core 104 can be a core with any shape and the toroidal core 104 is not limited to a toroidal core. A core of the toroidal core 104 can be enclosed or non-enclosed. The core of the toroidal core 104 even can be an air core.

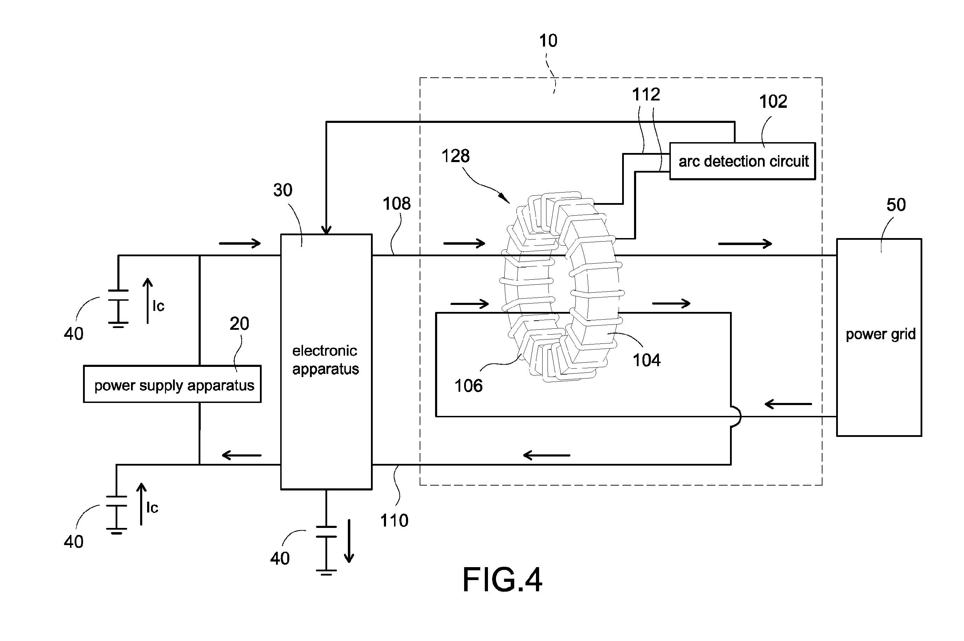

Fig. 4 shows a block diagram of the fourth embodiment of the arc detection apparatus of the present invention. In Fig. 4, the power supply apparatus 20 is a solar panel. The electronic apparatus 30 is an inverter. The inverter sends an alternating current voltage to a power grid 50. The arrows are indicated as the direction of the current. Besides detecting the direct current voltage, the present invention can detect the alternating current voltage as shown in Fig. 4 as well. The other contents of Fig. 4 are similar to the contents mentioned above and would be omitted here for brevity.

The advantage of the present invention is to provide the arc detection apparatus to improve the accuracy of the detection of the arc.

**Claims**

1. An arc detection apparatus (10) applied to a power supply apparatus (20) and an electronic apparatus (30), the arc detection apparatus (10) comprising:

   an arc detection circuit (102) electrically connected to the electronic apparatus (30);
   a current transforming unit (128) electrically connected to the arc detection circuit (102);
   a current input wire (108) through the current transforming unit (128) and electrically connected to the power supply apparatus (20) and the electronic apparatus (30); and
   a current output wire (110) through the current transforming unit (128) and electrically connected to the power supply apparatus (20) and the electronic apparatus (30),
   wherein the power supply apparatus (20) sends an input current (Iin_a) to the electronic apparatus (30) through the current input wire (108), and the electronic apparatus (30) sends back an output current (Iin_b) to the power supply apparatus (20) through the current output wire (110), so that the current transforming unit (128) induces and generates an induced current (112);
   wherein the current transforming unit (128) sends the induced current (112) to the arc detection circuit (102); the arc detection circuit (102) utilizes the induced current (112) to detect an arc.

2. The arc detection apparatus (10) in claim 1, wherein the current transforming unit (128) comprises:

   a toroidal core (104); and
   a toroidal coil (106) winding the toroidal core (104) and electrically connected to the arc detection circuit (102),

   wherein an input current direction of the input current (Iin_a) sent through the current input wire (108) through the toroidal core (104) is a first direction; an output current direction of the output current (Iin_b) sent through the current output wire (110) through the toroidal core (104) is the first direction.

3. The arc detection apparatus (10) in claim 2, wherein the first direction is from left to right; the input current (Iin_a) is sent from left to right through the current input wire (108) through the toroidal core (104); the output current (Iin_b) is sent from left to right through the current output wire (110) through the toroidal core (104).

4. The arc detection apparatus (10) in claim 2 or 3, wherein the first direction is from right to left; the input current (Iin_a) is sent from right to left through the current input wire (108) through the toroidal core (104); the output current (Iin_b) is sent from right to left through the current output wire (110) through the toroidal core (104).

5. The arc detection apparatus (10) in any of the claims 1 to 4, wherein the current transforming unit (128) comprises:

   a first toroidal core (114);
   a second toroidal core (120);
   a first toroidal coil (118) winding the first toroidal core (114) and electrically connected to the arc detection circuit (102); and

a second toroidal coil (116) winding the second toroidal core (120) and electrically connected to the arc detection circuit (102),

wherein the power supply apparatus (20) sends the input current (Iin_a) to the electronic apparatus (30) through the current input wire (108), so that the first toroidal core (114) and the first toroidal coil (118) induce and generate a first induced current (122); the electronic apparatus (30) sends back the output current (Iin_b) to the power supply apparatus (20) through the current output wire (110), so that the second toroidal core (120) and the second toroidal coil (116) induce and generate a second induced current (124);
wherein an input current direction of the input current (Iin_a) sent through the current input wire (108) through the first toroidal core (114) is a first direction; an output current direction of the output current (Iin_b) sent through the current output wire (110) through the second toroidal core (120) is the first direction;
wherein the first toroidal coil (118) sends the first induced current (122) to the arc detection circuit (102); the second toroidal coil (116) sends the second induced current (124) to the arc detection circuit (102); the arc detection circuit (102) utilizes the first induced current (122) and the second induced current (124) to detect the arc.

6. The arc detection apparatus (10) in claim 5, wherein the first direction is from left to right; the input current (Iin_a) is sent from left to right through the current input wire (108) through the first toroidal core (114); the output current (Iin_b) is sent from left to right through the current output wire (110) through the second toroidal core (120).

7. The arc detection apparatus (10) in claim 5 or 6, wherein the first direction is from right to left; the input current (Iin_a) is sent from right to left through the current input wire (108) through the first toroidal core (114); the output current (Iin_b) is sent from right to left through the current output wire (110) through the second toroidal core (120).

8. The arc detection apparatus (10) in any of the claims 1 to 7, wherein the current transforming unit (128) comprises:

    a first toroidal core (114);
    a second toroidal core (120);
    a first toroidal coil (118) winding the first toroidal core (114) and electrically connected to the arc detection circuit (102); and
    a second toroidal coil (116) winding the second toroidal core (120) and electrically connected to the arc detection circuit (102),

wherein the power supply apparatus (20) sends the input current (Iin_a) to the electronic apparatus (30) through the current input wire (108), so that the first toroidal core (114) and the first toroidal coil (118) induce and generate a first induced current (122); the electronic apparatus (30) sends back the output current (Iin_b) to the power supply apparatus (20) through the current output wire (110), so that the second toroidal core (120) and the second toroidal coil (116) induce and generate a second induced current (124);
wherein an input current direction of the input current (Iin_a) sent through the current input wire (108) through the first toroidal core (114) is a first direction; an output current direction of the output current (Iin_b) sent through the current output wire (110) through the second toroidal core (120) is a second direction; the first direction is different from the second direction;
wherein the first toroidal coil (118) sends the first induced current (122) to the arc detection circuit (102); the second toroidal coil (116) sends the second induced current (124) to the arc detection circuit (102); the arc detection circuit (102) reverses the second induced current (124) to obtain a reverse induced current; the arc detection circuit (102) utilizes the first induced current (122) and the reverse induced current to detect the arc.

9. The arc detection apparatus (10) in claim 8, wherein the arc detection circuit (102) comprises a current reverse unit (126); the current reverse unit (126) reverses the second induced current (124) to obtain the reverse induced current.

10. The arc detection apparatus (10) in claim 9, wherein the first direction is from left to right; the second direction is from right to left; the input current (Iin_a) is sent from left to right through the current input wire (108) through the first toroidal core (114); the output current (Iin_b) is sent from right to left through the current output wire (110) through the second toroidal core (120).

11. The arc detection apparatus (10) in claim 9 or 10, wherein the first direction is from right to left; the second direction is from left to right; the input current (Iin_a) is sent from right to left through the current input wire (108) through the first toroidal core (114); the output current (Iin_b) is sent from left to right through the current output wire (110) through the second toroidal core (120).

FIG.1

EP 3 171 472 A1

FIG.2

power supply apparatus

arc detection circuit

electronic apparatus

lin_a

lin_b

Ic

FIG.3

FIG.4

Europäisches Patentamt

European Patent Office

Office européen des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 599 523 B1 (OSTROVSKY MICHAEL [US] ET AL) 3 December 2013 (2013-12-03) * column 3, line 60 - column 10, line 8; figures 1,2 * | 1-7 | INV. H02H1/00 G01R31/02 |
| X | US 2015/155698 A1 (LI CHENGLI [CN] ET AL) 4 June 2015 (2015-06-04) | 1,8-11 | ADD. H02H3/33 |
| A | * paragraphs [0063], [0064]; figure 3 * | 2-7 | |
| X | US 2003/058596 A1 (MACBETH BRUCE F [US]) 27 March 2003 (2003-03-27) * paragraphs [0044] - [0046], [0053]; figures 2A,4 * | 1,8-11 | |
| X | WO 2011/151267 A2 (SHAKIRA LTD [IE]; WARD PATRICK [IE]; DANIELS BRIEN [IE]) 8 December 2011 (2011-12-08) | 1-4 | |
| A | * page 15, lines 1-14; figure 10 * | 8-11 | |

TECHNICAL FIELDS SEARCHED (IPC)

H02H
G01R

The present search report has been drawn up for all claims

| Place of search | Date of completion of the search | Examiner |
|---|---|---|
| Munich | 12 April 2017 | Trifonov, Antoniy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 17 5329

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2017

| Patent document cited in search report | | Publication date | Patent family member(s) | | Publication date |
|---|---|---|---|---|---|
| US 8599523 | B1 | 03-12-2013 | US<br>US | 8599523 B1<br>2014218044 A1 | 03-12-2013<br>07-08-2014 |
| US 2015155698 | A1 | 04-06-2015 | CN<br>US | 104678254 A<br>2015155698 A1 | 03-06-2015<br>04-06-2015 |
| US 2003058596 | A1 | 27-03-2003 | NONE | | |
| WO 2011151267 | A2 | 08-12-2011 | EP<br>WO | 2577826 A2<br>2011151267 A2 | 10-04-2013<br>08-12-2011 |

EPO FORM P0459

For more details about this annex : see Official Journal of the European Patent Office, No. 12/82